# EUROPEAN PATENT APPLICATION

(11) **EP 4 764 829 A1**
(43) Date of publication of application: **24.06.2026**
(21) Application number: 25225906.4
(22) Date of filing: 19.12.2025
(51) Int. Cl.: G06F 8/51

(54) **SYSTEMS AND METHODS FOR PROTOCOL DECODERS IN A SIGNAL ANALYSIS SYSTEM USING HARDWARE DESCRIPTION LANGUAGE**

(30) Priority: 20.12.2024 US 202418990983
(71) Applicant: Altera Corporation, San Jose, CA 95134 (US)
(72) Inventor: Peng, Yi, San Jose CA 95134 (US); Loh, Hong Lee, San Jose CA 95134 (US)
(74) Representative: Hermann, Felix

(57) **Abstract**

The embodiments described herein implement a protocol decoder tool designed by a hardware engineer in a hardware description language (HDL) in a simulator tool for testing and/or in a signal analysis system for decoding protocols in real-time. For example, a user (e.g., hardware engineer, hardware designer, protocol designer) may design a protocol using an HDL and design a protocol decoder tool for decoding the protocol in the HDL. Register transfer level (RTL) files with protocol decoder logic in the HDL may be converted from the HDL to a second language by a converter, compiled into a decoder module by a compiler, and executed in a signal analysis system as the protocol decoder tool. As such, errors in misinterpretation of protocol specifications may be reduced.

## Description

### BACKGROUND

The present disclosure relates generally to protocol decoders. More particularly, the present disclosure relates to designing a protocol decoder using a hardware description language and implementing the protocol decoder in a signal analysis system.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Protocol decoders may be used to interpret and analyze data protocols (e.g., communication protocols) from various devices. For example, the protocol decoder tool may receive and analyze raw communication signals in a protocol from an external device, interpret (e.g., decode) the signals based on rules and/or functions of the protocol decoder tool, and present decoded information in a human-readable format. The protocol decoder tool may display the decoded information in waveforms, tables, graphs, and/or text logs. The protocol decoder tool may be designed by a software engineer based on specifications from a hardware engineer who designed the protocol using a hardware description language (HDL). However, it may be difficult for the software engineer to understand the specifications. For example, it may be difficult for the software engineer to interpret specifications for a non-standard protocol and/or custom protocol designed by the hardware engineer.

### BRIEF DESCRIPTION OF THE DRAWINGS

Various aspects of this disclosure may be better understood upon reading the following detailed description and upon reference to the drawings in which:
FIG. 1 is a block diagram of a system used to program an integrated circuit device, in accordance with an embodiment of the present disclosure;
FIG. 2 is a block diagram of the integrated circuit device of FIG. 1, in accordance with an embodiment of the present disclosure;
FIG. 3 is a flow diagram for designing a protocol decoder tool and implementing the protocol decoder tool in a signal analysis system, in accordance with an embodiment of the present disclosure;
FIG. 4 is a block diagram of an embodiment of the signal analysis system implementing the protocol decoder tool of FIG. 3, in accordance with an embodiment of the present disclosure;
FIG. 5 is a block diagram of an embodiment of the signal analysis system of FIG. 3 decoding a protocol from the integrated circuit device of FIG. 1, in accordance with an embodiment of the present disclosure;
FIG. 6 is a block diagram of a simulator testing the protocol decoder tool of FIG. 3, in accordance with an embodiment of the present disclosure;
FIG. 7 is a schematic diagram of protocol decoder logic of the protocol decoder tool of FIG. 3, in accordance with an embodiment of the present disclosure;
FIG. 8 is a schematic diagram of an indication of a protocol displayed on the signal analysis system of FIG. 3, in accordance with an embodiment of the present disclosure;
FIG. 9 is a schematic diagram of decoded information displayed on the signal analysis system of FIG. 3, in accordance with an embodiment of the present disclosure;
FIG. 10 is flowchart of an example method for decoding communication in a protocol by the signal analysis system of FIG. 3, in accordance with an embodiment of the present disclosure; and
FIG. 11 is a block diagram of a data processing system including the integrated circuit device of FIG. 1, in accordance with an embodiment of the present disclosure.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time-consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

The present disclosure describes systems and techniques related to protocol decoders. In particular, the embodiments described herein implement a protocol decoder tool designed by a hardware engineer in a hardware description language (HDL). For example, a user (e.g., hardware engineer, hardware designer, protocol designer) may design a protocol using an HDL by defining specific electrical signal and/or data formats that different hardware components may use for communication. The user may also design a protocol decoder tool for decoding the protocol in the HDL. For example, the user may write (e.g., program) a register transfer level (RTL) file that includes protocol decoder logic in the HDL for the protocol decoder tool and the RTL file may be converted from the HDL to a second language by a converter, compiled into a decoder module by a compiler, and implemented in a signal analysis system as the protocol decoder tool. As such, errors in misinterpreting protocol specifications may be reduced.

The protocol decoder tool may, via the signal analysis system, receive communication (e.g., signals) in a protocol from an external system during processing operations of the external system, decode the communications, and generate decoded information based on the protocol. The signal analysis system may output an indication of the communication and the decoded information on a display. For example, the signal analysis system may include a waveform viewer that displays the decoded information overlaid on a waveform indicative of the communication. The protocol decoder tool may also transmit an injection signal to the integrated circuit device to cause (e.g., trigger) the integrated circuit device to perform a functionality.

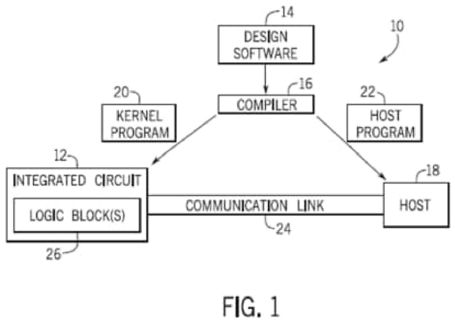

With the foregoing in mind, FIG. 1 illustrates a block diagram of a system 10 that may implement one or more functionalities. For example, a designer (e.g., a user, hardware engineer, hardware designer) may desire to implement functionality, such as the operations of this disclosure, on an integrated circuit device 12 (e.g., a programmable logic device, such as a field programmable gate array (FPGA) or an application specific integrated circuit (ASIC)). The integrated circuit device 12 may include a single integrated circuit, multiple integrated circuits in a package, or multiple integrated circuits in multiple packages communicating remotely (e.g., via wires or traces) and may be referred to as an integrated circuit device or an integrated circuit system, whether formed from a single integrated circuit or multiple integrated circuits in a package. In some cases, the designer may specify a high-level program to be implemented, such as an OpenCL^{®} program or SYCL^{®}, which may enable the designer to more efficiently and easily provide programming instructions to configure a set of programmable logic cells for the integrated circuit device 12 without specific knowledge of low-level hardware description languages (e.g., Verilog or VHDL). For example, since OpenCL^{®} is quite similar to other high-level programming languages, such as C++, designers of programmable logic familiar with such programming languages may have a reduced learning curve than designers that are required to learn unfamiliar low-level hardware description languages to implement new functionalities in the integrated circuit device 12.

The designer may implement high-level designs using design software 14, such as a version of INTEL^{®} QUARTUS^{®} by INTEL CORPORATION. The design software 14 may use a compiler 16 to convert the high-level program into a lower-level description. In some embodiments, the compiler 16 and the design software 14 may be packaged into a single software application. The compiler 16 may provide machine-readable instructions representative of the high-level program to a host 18 and the integrated circuit device 12. The host 18 may receive a host program 22 which may be implemented by the kernel programs 20. To implement the host program 22, the host 18 may communicate instructions from the host program 22 to the integrated circuit device 12 via a communications link 24, which may be, for example, direct memory access (DMA) communications or peripheral component interconnect express (PCIe) communications. In some embodiments, the kernel programs 20 and the host 18 may enable configuration of a logic block 26 on the integrated circuit device 12. The logic block 26 may include circuitry and/or other logic elements and may be configured to implement arithmetic operations, such as addition and multiplication.

The designer may use the design software 14 to generate and/or to specify a low-level program, such as the low-level hardware description languages described above. For example, the design software 14 may be used to map a workload to one or more routing resources of the integrated circuit device 12 based on a timing, a wire usage, a logic utilization, and/or a routability. Additionally or alternatively, the design software 14 may be used to route first data to a portion of the integrated circuit device 12 and route second data, power, and clock signals to a second portion of the integrated circuit device 12. Further, in some embodiments, the system 10 may be implemented without a host program 22 and/or without a separate host program 22. Moreover, in some embodiments, the techniques described herein may be implemented in circuitry as a non-programmable circuit design. Thus, embodiments described herein are intended to be illustrative and not limiting.

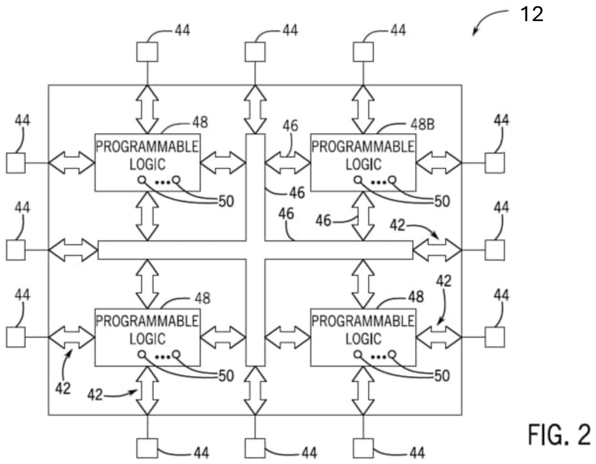

Turning now to a more detailed discussion of the integrated circuit device 12, FIG. 2 is a block diagram of an example of the integrated circuit device 12 as a programmable logic device, such as a field-programmable gate array (FPGA). Further, it should be understood that the integrated circuit device 12 may be any other suitable type of programmable logic device (e.g., a structured ASIC such as eASIC^{™} by Intel Corporation and/or application-specific standard product). The integrated circuit device 12 may have input/output circuitry 42 for driving signals off the device and for receiving signals from other devices via input/output pins 44. Interconnection resources 46, such as global and local vertical and horizontal conductive lines and buses, and/or configuration resources (e.g., hardwired couplings, logical couplings not implemented by designer logic), may be used to route signals on integrated circuit device 12. Additionally, interconnection resources 46 may include fixed interconnects (conductive lines) and programmable interconnects (e.g., programmable connections between respective fixed interconnects). For example, the interconnection resources 46 may be used to route signals, such as clock or data signals, through the integrated circuit device 12. Additionally or alternatively, the interconnection resources 46 may be used to route power (e.g., voltage) through the integrated circuit device 12. Programmable logic 48 may include combinational and sequential logic circuitry. For example, programmable logic 48 may include look-up tables, registers, and multiplexers. In various embodiments, the programmable logic 48 may be configured to perform a custom logic function. The programmable interconnects associated with interconnection resources may be considered to be a part of programmable logic 48.

Programmable logic devices, such as the integrated circuit device 12, may include programmable elements 50 with the programmable logic 48. In some embodiments, at least some of the programmable elements 50 may be grouped into logic array blocks (LABs). As discussed above, a designer (e.g., a user, a customer) may (re)program (e.g., (re)configure) the programmable logic 48 to perform one or more desired functions. By way of example, some programmable logic devices may be programmed or reprogrammed by configuring programmable elements 50 using mask programming arrangements, which is performed during semiconductor manufacturing. Other programmable logic devices are configured after semiconductor fabrication operations have been completed, such as by using electrical programming or laser programming to program the programmable elements 50. In general, programmable elements 50 may be based on any suitable programmable technology, such as fuses, anti-fuses, electrically programmable read-only-memory technology, random-access memory cells, mask-programmed elements, and so forth.

Many programmable logic devices are electrically programmed. With electrical programming arrangements, the programmable elements 50 may be formed from one or more memory cells. For example, during programming, configuration data is loaded into the memory cells using input/output pins 44 and input/output circuitry 42. In one embodiment, the memory cells may be implemented as random-access-memory (RAM) cells. The use of memory cells based on RAM technology as described herein is intended to be only one example. Further, since these RAM cells are loaded with configuration data during programming, they are sometimes referred to as configuration RAM cells (CRAM). These memory cells may each provide a corresponding static control output signal that controls the state of an associated logic component in programmable logic 48. In some embodiments, the output signals may be applied to the gates of metal-oxide-semiconductor (MOS) transistors within the programmable logic 48.

The components within the integrated circuit device 12 may communicate via protocols. For example, the integrated circuit device 12 may use a communication protocol to transmit data packets from a first region of the integrated circuit device 12 to another region of the integrated circuit device 12. Additionally or alternatively, the integrated circuit device 12 may communicate with other external devices (e.g., memory devices) using protocols. By way of example, the integrated circuit devices 12 may use serial communication protocols for data exchange between microcontrollers and/or memory devices, memory protocols for interfacing with memory devices, networking protocols for data communication with networks, and/or power management protocols for managing power delivery and/or monitoring. In another example, the integrated circuit device 12 may be tested and/or validated after implementing a design. During testing, the integrated circuit device 12 may output communication in one or more protocols that may be used to validate the implemented design. As such, it may be beneficial to decode received communication in these protocols during development and/or integration of the integrated circuit device 12 to validate the behavior of the integrated circuit device 12 under different conditions and/or with different devices. As used herein, decoding a protocol may refer to the process of interpretating and converting signal data of the protocol (e.g., communication in the protocol) into a human-readable or usable format. As used herein, "decoding the communication in a protocol" and/or "decoding signal data of the protocol" may refer to interpreting and/or translating the signal data based on rules and/or structure defined by the protocol. It may be beneficial to decode communication in a protocol to validate and/or verify that communication transmitted by be understood and/or acted upon by the receiving system. In certain instances, decoding the communication may include identifying a state of the protocol, which may refer to a current phase or condition of a communication session within the protocol. In another example, decoding the communication may include identifying a function of the protocol, which may refer to a role and/or a function the protocol may serve within the integrated circuit device 12. For example, the function of the protocol may define how communication may be carried out to achieve certain goals. By decoding the communication, a user may identify errors in communication within the integrated circuit device 12 and/or with other devices, errors in data transmission, or both.

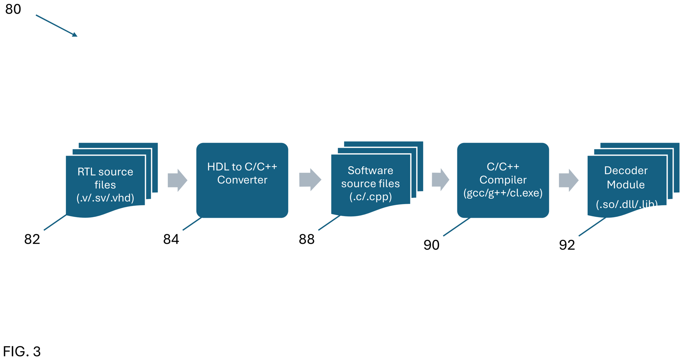

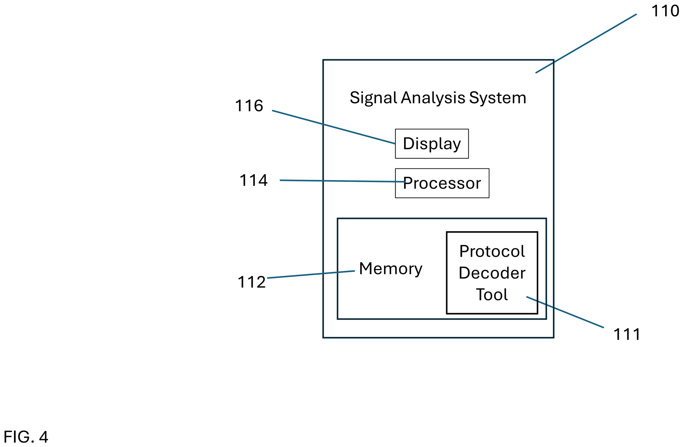

With the foregoing in mind, FIG. 3 illustrates a flow diagram 80 for designing and implementing a protocol decoder tool (e.g., the protocol decoder tool 113 of FIGS. 4-6) within a data analysis system (e.g., the signal analysis system 110 of FIGS. 4-6). To design the protocol decoder tool, a user (e.g., hardware engineer) may write (e.g., program) protocol decoder logic using a hardware description language (HDL). The protocol decoder tool may be designed to decode communication in any suitable type of protocol based on the rules and/or structure of the protocol, which may also be designed by the user. For example, the protocol decoder logic may be stored in RTL source files 82 and include parameters of the protocol decoder tool. The parameters may include inputs, outputs, transition conditions, initial conditions, and stop conditions of the protocol decoder tool. In another example, the protocol decoder logic may include functions, that when called, cause the protocol decoder tool to perform a decoding operation. As further described herein, the functions may include an init() function for initializing the decoding operations, a get() function to receive signal data, a set() function to send decoded data, and/or a check_completion() function to check if all stop conditions are met. For transitions, such as at a positive edge of a clock signal, the get() function and/or the set() function may be called. The get() function may retrieve one or more inputs that may be specified by the designer via the protocol decoder logic and the set() function may set one or more outputs. The functions may cause the protocol decoder tool to initialize decoding operations, retrieve signal values of the protocol and/or the communication in the protocol, decode the communication, report decoded information (e.g., decoded result), terminate operation, check if stop conditions are met, and so on.

In certain instances, the signal analysis system may implement multiple protocol decoder tools. As such, the RTL source files 82 may include specifications for a signal interface between the multiple protocol decoder tools and the signal analysis system. For example, the specifications may include three key areas: signal type, signal properties, and signal roles. The signal interface may use the signal type to associate a respective protocol decoder with communication in a corresponding protocol. For example, the signal types may include communication in different types of protocols, such as bus protocols (e.g., Peripheral Component Interconnect Express (PCIe), BUS, Advanced eXtensible Interface (AXI)), serial communication protocols (e.g., inter-integrated circuit (I2C), serial peripheral interface (SPI)), memory protocols, debugging protocols (e.g., Joint Test Action Group (JTAG), Universal Asynchronous Receiver-Transmitter (UART)), custom protocols, and so on. The signal properties may include parameters of the protocol. For example, the signal interface may pass signal property values (e.g., signal data) of the protocol to the protocol decoder tool in a format of module instantiation parameters. The signal roles may include functions performed by the protocol within a device and/or system. The signal roles may define how the protocol interacts with components, systems, and/or devices to generate an outcome. For example, the signal interface may bind a protocol to a respective protocol decoder tool based on the signal role rather than a signal name. For example, the signal received by a signal analysis system may include a signal name, which may be set by a designer of the signal and vary from designer to designer. The interface may map a signal to a protocol decoder based on the signal role, which may not change based on the designer.

The RTL source files 82 may be converted from a first language and/or framework to a second language and/or framework. For example, a converter 84 may receive the RTL source files 82 in an HDL and convert the RTL source files 82 into software source files 88, which may be in the second language. For example, the converter 84 may include a Verilator converter that converts the RTL source files 82 from an HDL, such as Verilog, to a software language, such as C/C++. In other words, the software source files 88 may be in a human-readable code. The software source files 88 may include the protocol decoder logic in the second language. For example, the software source files 88 may define instructions, functions, logic, and/or behavior of the protocol decoder tool in the second language.

A compiler 90 may receive the software source files 88 and compile the software source files 88 to a decoder module 92. For example, the compiler 90 may be a C/C++ compiler that compiles the software source files 88 into the decoder module 92, which may be implemented into a system. That is, the decoder module 92, when executed by a processor, may cause the processor to implement the protocol decoder tool. For example, the processor may perform operations corresponding to the protocol decoder logic of the protocol tool.

The decoder module 92 may be implemented in a signal analysis system, which may execute the protocol decoder tool to decode a signal in one or more protocols. The decoder module 92 may include shared libraries with functions of the protocol decoder logic. For example, the decoder module 92 may include shared objects for a Linux operating system, dynamic link library for a Windows operating system, and/or static libraries linked at compile time. The protocol decoder tool may call one or more functions of the shared library to receive a protocol, decode the protocol information to generate decoded information, and transmit the decoded information to the signal analysis system.

With the foregoing in mind, FIG. 4 is a block diagram of a signal analysis system 110 instantiating the protocol decoder tool 111. The signal analysis system 110 may include a visualization tool, a signal waveform viewer, a dedicated protocol analyzer, and so on. As illustrated in FIG. 4, the signal analysis system 110 may include a memory 112, a processor 114, and a display 116. The processor 114 may be any type of computer processor or microprocessor capable of executing computer-executable code. The memory 112 may include any suitable articles of manufacture that can serve as media to store processor-executable code, data, or the like. For example, the memory 112 may be loaded with one or more decoder modules 92 and the processor 114 may execute a decoder module 92 to initialize (e.g., execute) the protocol decoder tool 111. These articles of manufacture may represent non-transitory computer-readable media (i.e., any suitable form of memory or storage) that may store the processor-executable code used by the processor 114 to perform the presently disclosed techniques.

The display 116 may include any type of electronic display such as a liquid crystal display, a light-emitting-diode display, and the like. As such, signal data of the protocol (e.g., communication in a protocol) acquired by the signal analysis system 110 and/or data analyzed by the processor 114 and/or the protocol decoder tool 111 may be presented on the display 116. For example, the signal analysis system 110 may display an indication of the communication in the protocol and decoded information associated with the communication. In certain embodiments, the display 116 may be a touch screen display or any other type of display capable of receiving inputs from an operator. Although the signal analysis system 110 is described as including the components presented in FIG. 4, the signal analysis system 110 should not be limited to including the components listed in FIG. 4. Indeed, the signal analysis system 110 may include additional or fewer components than described above. For example, the signal analysis system 110 may include one or more kernels that execute the decoder module 92 to execute the protocol decoder tool 111.

The decoder module 92 may be loaded into the signal analysis system 110 at run-time based on a type of protocol. In other instances, the decoder module 92 may be loaded into the memory 112 and executed at a later time for protocol decoding. For example, the signal analysis system 110 may store multiple decoder modules 92 for decoding communication in respective protocols. The decoder module 92 may be dynamically loaded and unloaded as need, which may improve flexibility of the signal analysis system 110 since the user may load functionalities as needed. For example, the user may select a decoder module 92 from multiple different decoder modules 92 for instantiation based on an external device and/or corresponding signal types, signal properties, and signal roles of a protocol generated by the external device and the protocol associated with the decoder module 92. Additionally or alternatively, the user may switch out the decoder modules 92 without modifying or restarting the signal analysis system (e.g., using partial reconfiguration).

The decoder module 92 may be executed by the processor 114 to execute the protocol decoder tool 111. The protocol decoder tool 111, via the signal analysis system 110, may receive a protocol from an external device, generate decoded information by decoding the protocol based on protocol decoder logic of the protocol decoder tool 111, and display cause the display 116 to display an indication of the protocol and decoded information. The display 116 may display the indication of the communication in the protocol as a waveform and overlay the decoded information onto the waveform. The protocol decoder tool 111 may express the decoded information may be expressed as an HDL type. For example, the decoded information may be expressed as enum. The signal analysis system 110 may display the decoded information on the display 116 in simple text or formatted text. For example, the decoded information may be displayed in JSON, YAML, XML, HTML/CSS, and so on. As such, the signal analysis system 110 may receive communication in a protocol (e.g., signal data of the protocol) and display an indication of the protocol along with decoded information.

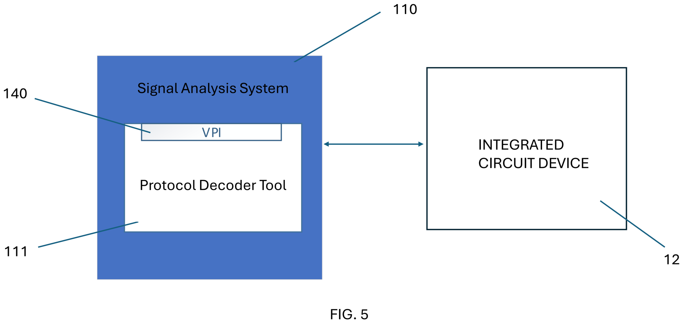

FIG. 5 is a block diagram of the signal analysis system 110 communicatively coupled to an integrated circuit device 12. After implementing a design on the integrated circuit device 12, the integrated circuit device 12 may undergo testing (e.g., validation). During the testing, the integrated circuit device 12 may generate signals in one or more protocols, which may be received and decoded by the signal analysis system 110. In another example, the integrated circuit device 12 may process data (e.g., a data packet) and transmit the data within the integrated circuit device 12 and/or to other devices in one or more protocols. The signal analysis system 110 may receive communication in the one or more protocols for decoding. The decoded information may be compared against known results to validate the integrated circuit device 12. For example, the decoded information may be used to identify errors in the implemented design, miscommunication within the integrated circuit device 12, miscommunication between the integrated circuit device 12 and/or other devices, validate the design, and so on.

As illustrated, the signal analysis system 110 may include the protocol decoder tool 111 communicatively coupled to a Verilog Procedural Interface (VPI) 140. At runtime, the VPI 140 may exchange data between the protocol decoder tool 111 and the signal analysis system 110. The VPI 140 may enable a software library to be deployed in the signal analysis system 110 with callable functions. For example, the signal analysis system 110 may receive signal data of a protocol from the integrated circuit device 12 and the signal data may be sent to the protocol decoder tool 111 over the VPI 140 in response to the protocol decoder tool 111 calling a get() function. In another example, decoded information may be sent from the protocol decoder tool 111 to the signal analysis system 110 via the VPI 140 in response to the protocol decoder tool 111 calling a set() function. Although the illustrated the signal analysis system 110, includes the VPI 140, in other embodiments, it may be understood that the signal analysis system 100 may includea Direct Programming Interface (DPI) that enables deployment of the software library and facilitates data transmission between the protocol decoder tool 111 and the signal analysis system 110.

The protocol decoder tool 111 may decode a signal in a protocol using the protocol decoder logic. For example, the protocol decoder tool 111 may receive communication in a protocol and decode from the integrated circuit device 12 and decode the communication using the protocol decoder logic in real-time. The protocol decoder tool 111 may call a get() function to get one or more inputs and call a set() function to set one or more outputs. Once the signal in the protocol is decoded, the protocol decoder tool 111 may call a set() function to cause the VPI 140 to transmit the decoded information back to the signal analysis system 110.

The signal analysis system 110 may display the decoded information and an indication of the communication on the display 116. For example, the signal analysis system 110 may display a waveform of the communication on the display 116 and overlay the decoded information on top of the waveform.

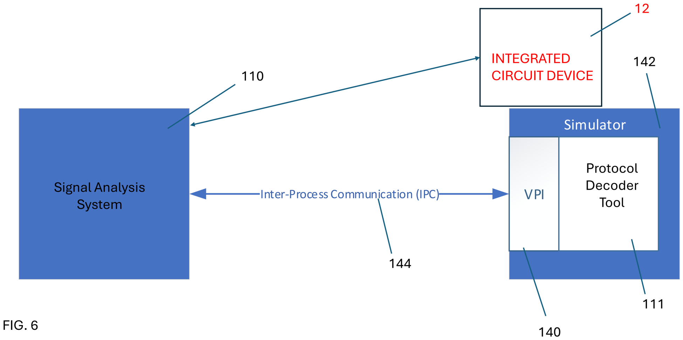

FIG. 6 is a block diagram of the protocol decoder tool 111 executed by a simulator tool 142 for testing. During development of the protocol decoder tool 111, the protocol decoder logic may be tested with the simulator tool (e.g., simulation test bench) 142 that executes the protocol decoder tool 111, links to a function implementation, and executes a decoded result verifier. The simulator tool 142 may receive and execute the protocol decoder tool 111 in an HDL to test the decoder logic. For example, the simulator tool 142 may receive and store the RTL source files 82 in memory and execute the RTL source files 82 to execute the protocol decoder tool 111. In another example, the protocol decoder tool 111 may initialize the simulator tool 142. In certain instances, the functions of the protocol decoder logic may be implemented differently during protocol decoder development. For example, the protocol decoder logic may include VPI/DPI functions in an HDL. As such, the protocol decoder logic may be implemented in an HDL, the protocol decoder logic may be tested and/or validated using an HDL simulation tool, independent of the signal analysis system 110.

As illustrated, the signal analysis system 110 may be communicatively coupled to the simulator tool 142 via an inter-process communication (IPC) channel 144. The simulator tool 142 may include any suitable electronic design automation (EDA) tool. The IPC channel 144 may include a communication channel within the system and transmit data between the signal analysis system 110 and the simulator tool 142. Additionally or alternatively, the IPC channel 144 may include a shared memory communication mechanism to exchange simulation events and/or data (e.g., test signal data) between the simulator tool 142 and the signal analysis system 110. In certain instances, the signal analysis system 110 and the simulator tool 142 may be integrated within one system, such as the same computing device. In other instances, the signal analysis system 110 and the simulator tool 142 may be separate systems.

The signal analysis system 110 may be coupled to the integrated circuit device 12 to receive test signal data. The signal analysis system 110 may pass the test signal data to the protocol decoder tool 111 for testing. The protocol decoder tool 111 may receive, via the simulation tool 142, the test signal data as an input vector. In certain instances, the designer (e.g., user) may create the test signal data for a specific code coverage purpose. In other instances, the signal analysis system 110 may generate the test signal data based on collected data from the integrated circuit device 12, such as previous signal data of one or more protocols. The signal analysis system 110 may store the test signal data in a format that may be loaded independently without hardware system dependency. The signal analysis system 110 may transmit the test signal data to the simulator tool 142 via the IPC channel 144.

The protocol decoder tool 111 may generate reported results by processing the test signal data using the protocol decoder logic. The protocol decoder tool 111 may express the reported results as an HDL type. The protocol decoder tool 111 may transmit the reported results to the signal analysis system 110 via the VPI 140 by calling a set() function and the IPC channel 144. The signal analysis system 110 may verify the reported results against known outputs associated with the test signal data. For example, the signal analysis system 110 may determine if the reported results match known outputs stored in the memory 112 of the signal analysis system 110. If the results match, the signal analysis system 110 may display an indication of validating (e.g., verifying) the protocol decoder tool 111 via the display 116. If the results do not match, the signal analysis system 110 may display an indication of error and/or an indication of the reported results via the display 116. Additionally or alternatively, the signal analysis system 110 may display an indication of the reported results in simple text and/or formatted text on the display 116.

In certain instances, the protocol decoder tool 111 may transmit an injection signal to the signal analysis system 110 to test and/or validate the integrated circuit device 12. For example, the protocol decoder tool 111 may transmit the injection signal during the decoding process to test and/or validate the integrated circuit device 12. The injection signal may include a signal that may not be part of the decoding input and/or a modified signal (e.g., signal value) which may trigger an action from the integrated circuit device 12.

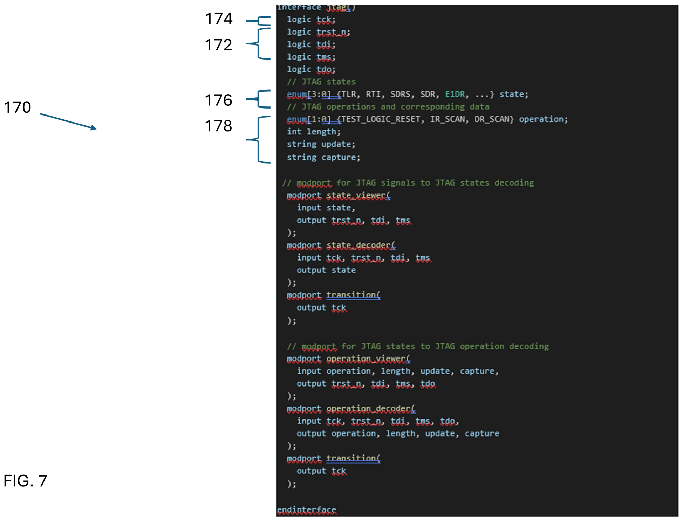

FIG. 7 is a schematic diagram of an embodiment of protocol decoder logic 170. As illustrated, the protocol decoder logic 170 may be a Joint Test Action Group (JTAG) interface used for testing and debugging integrated circuit devices, such as the integrated circuit device 12. It may be understood that the example of FIG. 7 is merely illustrative, and the protocol decoder logic 170 may include any suitable protocol decoder logic for decoding any suitable protocol.

The protocol decoder logic 170 may include callable functions in a human-readable code. By way of example, the callable functions may include functions for decoding JTAG states. In the example shown in FIG. 7, inputs 172 may include: logic trst_n, logic_tdi, logic_tms; an output may include enum[3:0] next_state; a transition condition 174 may include logic_tck; an initial condition may include enum[3:0] initial_state; and an stop condition may include bit_stop. As an example, a function prototype for decoding a JTAG state 176 may include init(enum[3:0] initial_state); get (int_id, logic trst_n, logic_tms); set (int_id, enum[3:0] next_state); and check_completion(bit_stop). For example, the protocol decoder tool 111 may call an initial() function to receive an initial state, the get() function to receive the inputs, the set() function to set an output, and/or call the check completion() function to determine if the decoding operation is complete.

By way of illustrative example, the protocol decoder logic 170 for decoding JTAG functions (e.g., operations) 178. For example, inputs may include enum[3:0] state; outputs may include enum[3:0] operation, int length, string update, and/or string capture; a transition condition may include logic tck; an initial condition may include enum [3:0] initial_state; and a stop condition may include bit stop. As an example, the function prototype for decoding JTAG functions 178 may include init(enum[3:0] initial_state); get (int_id, enum[3:0] state); set(int_id, enum[3:0] operation, int_length, string_update, string_capture); and check_completion(bit_stop).

As discussed herein, the protocol decoder logic 170 may be executed by the simulator tool 142 to test the protocol decoder logic 170 and/or the signal analysis system 110 to decode a signal in a protocol.

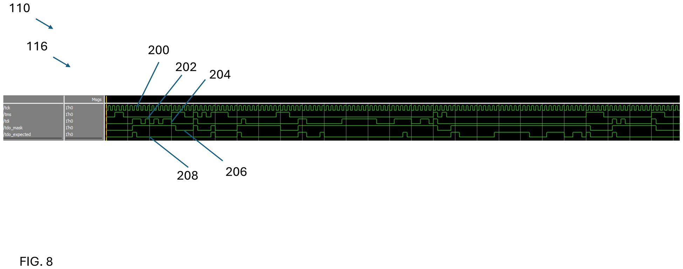

FIG. 8 is a schematic diagram of an example protocol displayed on the display 116 of the signal analysis system 110. The signal analysis system 110 may display a first waveform 200 indicative of a clock signal of the communication of the protocol, a second waveform 202 indicative of a state of the protocol, a third waveform 204 indicative of input test data (e.g., test signal), a fourth waveform 206 indicative of a recorded result, and/or a fifth waveform 208 indicative of a known result (e.g., expected result). The waveforms 200, 202, 204, 206, and 208 may be captured and/or displayed by the signal analysis system 110 in real-time.

For example, the signal analysis system 110 may capture and display the waveforms 200, 202, 204, 206, and 208 as the integrated circuit device 12 is processing data. In another example, the signal analysis system 110 may capture and display the waveforms 200, 202, 204, 206, and 208 during testing and/or validation of the integrated circuit device 12. To validate the protocol decoder logic, for example, the signal analysis system 110 may compare the fourth waveform 206 to the fifth waveform 208. If the waveforms match, then the signal analysis system 110 may output an indication of validation. In the waveforms do not match, then the signal analysis system 110 may output an indication of error.

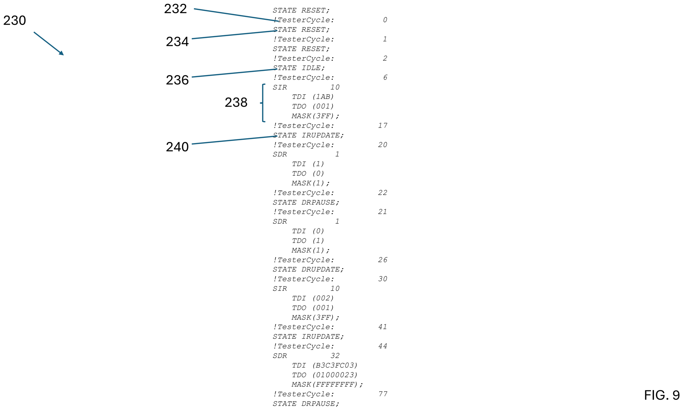

FIG. 9 is a schematic diagram of decoded information (e.g., recorded result) 230 by the protocol decoder tool 111. By way of illustrative example, the protocol decoder tool 111 may generate the decoded information 230 by decoding the test signal data discussed with respect to FIG. 8. The test cycle 232 may indicate a point in time for at least a portion of the decoded information 230 to be overlaid onto a respective waveform 220, 222, 224, 226, and 228. For example, at clock = 0 and clock = 1, the decoded information 230 may indicate a reset state 234 of the protocol. At clock = 2, the decoded information 230 may indicate an idle state 236 of the protocol.

At clock = 36, the decoded information 230 may indicate a test cycle 238 of the protocol. The test data in (TDI) may be a function for receiving test data, which as illustrated includes (1AB). The test data out (TDO) may output a recorded result, which as illustrated includes (001). The signal analysis system 110 may overlay the recorded result onto the fourth waveform 206 illustrated in FIG. 8 at a corresponding clock cycle (e.g., clock = 36). Following the test cycle, at clock = 17, the decoded information 230 may indicate that the state of the protocol may be shifted (illustrated as IRUPDATE 240).

At clock = 22, clock = 30, and clock = 44, the decoded information 230 may indicate a test cycle 238 of the protocol. The signal analysis system 110 may display the decoded information 230 as simple text overlaid onto a corresponding waveform at a corresponding clock cycle on the display 116. As such, the decoded information 230 may be overlaid onto the indication of the protocol.

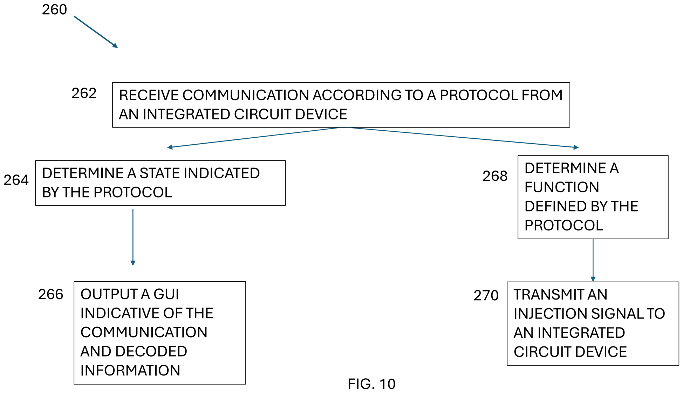

FIG. 10 is a flow diagram of an example method 260 for decoding a protocol and displaying the decoded information. The method 260 includes various actions represented by blocks. Although the flowchart illustrates the actions in a certain sequence, it should be understood that the actions may be performed in any suitable order and certain actions may be carried out simultaneously, where appropriate. Further, certain actions or portions of the method 260 may be performed by separate systems or devices.

At block 262, the protocol decoder tool 111 may receive communication according to a protocol from an integrated circuit device 12. The integrated circuit device 12 may generate the communication during testing and/or debugging of the integrated circuit device 12, while processing data, while transmitting data, and so on. The signal analysis system 110 may be communicatively coupled to the integrated circuit device 12 and receive the protocol from the integrated circuit device 12. The protocol decoder tool 111 may receive the communication and/or signal data values of the protocol via the VPI 140 by calling a get() function.

At block 264, the protocol decoder tool 111 may determine a state of the protocol. For example, the protocol decoder tool 111 may call a set() function to set a value of the decoded information.

At block 268, the protocol decoder tool 111 may output a graphical user interface (GUI) indicative of an indication of the communication and decoded information. For example, the graphical user interface may include one or more waveform indicative of the protocol. The decoded information, such as the state of the protocol and/or the function of the protocol, may be overlaid onto a respective waveform at a corresponding clock cycle. As such, the communication and the decoded information may be presented to the user in real-time.

At block 268, the protocol decoder tool 111 may determine a function of the protocol. If certain conditions may be satisfied (e.g., conditions of the protocol decoder logic, then the protocol decoder tool 111 may identify an injection signal for introducing a functionality into the integrated circuit device 12.

At block 270, the protocol decoder tool 111 may transmit an injection signal to an integrated circuit device 12. The injection signal may introduce a functionality to into the integrated circuit device 12. For example, the injection signal may introduce an error to the integrated circuit device 12 to test and/or validate the integrated circuit device 12 and/or evaluate a response of the integrated circuit device 12. In another example, the injection signal may include a modified signal to override a value of the signal on the integrated circuit device 12. In other words, the transmitting the injection signal may cause an internal state of the signal within the integrated circuit device 12 to change (e.g., override). That is, the injection signal may adjust (e.g., override) the signal value within the integrated circuit device 12. As such, a designer may use the injection signal to purposely trigger a signal value, to start a verification setup. In certain instances, the method 260 may return to block 262 based on user design (e.g., test design by the user).

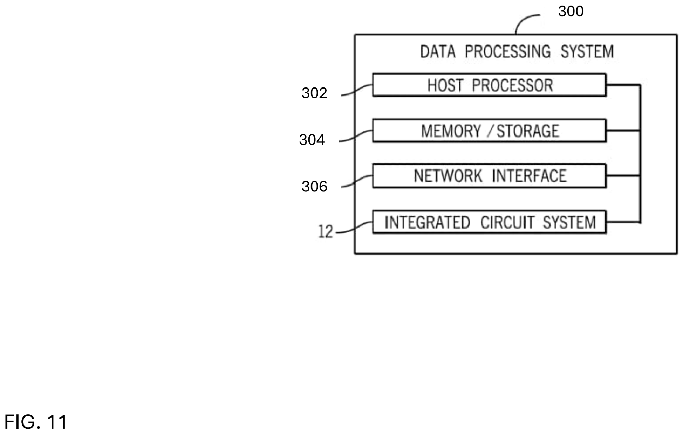

Bearing the foregoing in mind, the integrated circuit device 12 may be a component included in a data processing system, such as a data processing system 300, shown in FIG. 11. The data processing system 300 may include the integrated circuit device 12 (e.g., a programmable logic device), a host processor 302 (e.g., a processor), memory and/or storage circuitry 304, and a network interface 306. The data processing system 300 may include more or fewer components (e.g., electronic display, designer interface structures, ASICs). Moreover, any of the circuit components depicted in FIG. 11 may include integrated circuits (e.g., integrated circuit device 12). The host processor 302 may include any of the foregoing processors that may manage a data processing request for the data processing system 300 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 304 may include random access memory (RAM), read-only memory (ROM), one or more hard drives, flash memory, or the like. The memory and/or storage circuitry 304 may hold data to be processed by the data processing system 300. In some cases, the memory and/or storage circuitry 304 may also store configuration programs (bit streams) for programming the integrated circuit device 12. The network interface 306 may allow the data processing system 300 to communicate with other electronic devices. The data processing system 300 may include several different packages or may be contained within a single package on a single package substrate. For example, components of the data processing system 300 may be located on several different packages at one location (e.g., a data center) or multiple locations. For instance, components of the data processing system 300 may be located in separate geographic locations or areas, such as cities, states, or countries.

In one example, the data processing system 300 may be part of a data center that processes a variety of different requests. For instance, the data processing system 300 may receive a data processing request via the network interface 306 to perform encryption, decryption, machine learning, video processing, voice recognition, image recognition, data compression, database search ranking, bioinformatics, network security pattern identification, spatial navigation, digital signal processing, or some other specialized task.

The above discussion has been provided by way of example. Indeed, the embodiments of this disclosure may be susceptible to a variety of modifications and alternative forms. For example, multiple decoder modules 92 may be designed by a user, converted from a first language to a second language, compiled into respective protocol decoder tools 111. The protocol decoder tool 111 may be designed to decode a respective protocol or a respective group of protocols. Since the protocol decoder tool 111 is designed using an HDL, the protocol decoder tool 111 may be developed and validated using an HDL simulation tool, independent of the signal analysis system 110. After the validation, the protocol decoder tool 111 may be implemented by the signal analysis system 110 to decode a protocol. Indeed, different protocol decoder tools 111 may be loaded into the signal analysis system 110 for decoding a variety of different protocols from a variety of devices. Furthermore, the protocol decoder tools 111 may be switched out by the user based on their functionalities.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

### EXAMPLE EMBODIMENTS

**EXAMPLE EMBODIMENT 1.** A tangible, non-transitory, computer-readable medium comprising computer readable code that, when executed by a data processing system, causes the data processing system to perform operations comprising: receiving a first set of source files comprising protocol decoder logic in a hardware description language, generating a second set of source files by converting the protocol decoder logic from the hardware description language to a second language, generating a protocol decoder module by compiling the second set of source files in the second language, and instantiating a protocol decoder tool by executing the protocol decoder module.

**EXAMPLE EMBODIMENT 2.** The tangible, non-transitory, computer-readable medium of example embodiment 1, wherein the operations comprise executing the protocol decoder tool by loading the protocol decoder module in a simulator tool for validation prior to executing the protocol decoder module.

**EXAMPLE EMBODIMENT 3.** The tangible, non-transitory, computer-readable medium of example embodiment 2, wherein the simulator tool comprises a hardware description language simulator to execute the protocol decoder tool using the first set of source files.

**EXAMPLE EMBODIMENT 4.** The tangible, non-transitory, computer-readable medium of example embodiment 3, wherein the operations comprise validating the protocol decoder tool by: transmitting input data to the simulator tool; and validating the protocol decoder tool based on a comparison between outputted results from the protocol decoder tool and stored results in a database.

**EXAMPLE EMBODIMENT 5.** The tangible, non-transitory, computer-readable medium of example embodiment 1, wherein the operations comprise transmitting communication in a protocol from an external device to the protocol decoder tool, displaying an indication of the communication and overlaying decoded information from the protocol decoder tool onto the indication.

**EXAMPLE EMBODIMENT 6.** The tangible, non-transitory, computer-readable medium of example embodiment 5, wherein the decoded information is displayed as simple text or formatted text.

**EXAMPLE EMBODIMENT 7.** The tangible, non-transitory, computer-readable medium of example embodiment 1, wherein the operations comprise transmitting an injection signal to an integrated circuit device.

**EXAMPLE EMBODIMENT 8.** The tangible, non-transitory, computer-readable medium of example embodiment 7, wherein the operations comprise transmitting communication in a protocol from an external device to the protocol decoder tool via an interface, and wherein the interface transmits the protocol to the protocol decoder tool in response to the protocol decoder tool calling a function of the library of callable functions.

**EXAMPLE EMBODIMENT 9.** The tangible, non-transitory, computer-readable medium of example embodiment 1, wherein the second language comprises C or C++.

**EXAMPLE EMBODIMENT 10.** A system comprising a processing system comprising one or more processors and a memory storing instructions that, when executed by the processing system, causes the processing system to: execute a protocol decoder tool by executing a protocol decoder module by at least one processor of the one or more processors, wherein the protocol decoder module is generated by compiling a set of source files that are converted from a hardware description language to a second language, transmit communication in a protocol to the protocol decoder tool. and output via a graphical user interface an indication of the communication and decoded information from the protocol decoder tool.

**EXAMPLE EMBODIMENT 11.** The system of example embodiment 10, wherein the decoded information comprises a state of the protocol.

**EXAMPLE EMBODIMENT 12.** The system of example embodiment 11, wherein the protocol decoder tool is executed with an interface to transmit the communication to the protocol decoder tool in response to the protocol decoder tool calling a first function; and transmit the decoded information from the protocol decoder tool to at least one processor of the one or more processors in response to the protocol decoder tool calling a second function, wherein the first function and the second function are different.

**EXAMPLE EMBODIMENT 13.** The system of example embodiment 10, wherein the set of source files comprises protocol decoder language in the hardware description language.

**EXAMPLE EMBODIMENT 14.** The system of example embodiment 10, wherein the indication comprises at least one waveform corresponding to the protocol, and wherein the decoded information is overlaid onto the at least one waveform.

**EXAMPLE EMBODIMENT 15.** The system of example embodiment 10, wherein the protocol decoder is executed with an interface to transmit an injection signal to an integrated circuit device communicatively coupled to the system.

**EXAMPLE EMBODIMENT 16.** A system comprising a signal analysis system to generate a test signal and a simulator tool communicatively coupled to the signal analysis system, the simulator tool comprising a protocol decoder tool comprising protocol decoder logic in a hardware description language; and an interface to transmit the test signal from the signal analysis system to the protocol decoder tool and transmit a reported result from the protocol decoder tool to the signal analysis system.

**EXAMPLE EMBODIMENT 17.** The system of example embodiment 16, wherein the signal analysis system validates the protocol decoder tool based on a comparison between the reported result from the protocol decoder tool and known results stored in a memory of the signal analysis system.

**EXAMPLE EMBODIMENT 18.** The system of example embodiment 17, wherein the signal analysis system outputs a graphical user interface (GUI) indicative of the comparison.

**EXAMPLE EMBODIMENT 19.** The system of example embodiment 16, wherein the protocol decoder tool calls a first function to receive the test signal from the interface and calls a second function to transmit the reported result to the interface, wherein the first function and the second function are different.

**EXAMPLE EMBODIMENT 20.** The system of example embodiment 16, comprising a communication channel coupling the signal analysis system and the simulator tool, wherein the communication channel transmits the test signal to the interface and transmits the reported result to the signal analysis system.

## Claims

1. A tangible, non-transitory, computer-readable medium comprising computer readable code that, when executed by a data processing system, causes the data processing system to perform operations comprising:
receiving a first set of source files comprising protocol decoder logic in a hardware description language;
generating a second set of source files by converting the protocol decoder logic from the hardware description language to a second language;
generating a protocol decoder module by compiling the second set of source files in the second language; and
instantiating a protocol decoder tool by executing the protocol decoder module.

2. The tangible, non-transitory, computer-readable medium of claim 1, wherein the operations comprise executing the protocol decoder tool by loading the protocol decoder module in a simulator tool for validation prior to executing the protocol decoder module.

3. The tangible, non-transitory, computer-readable medium of claim 2, wherein the simulator tool comprises a hardware description language simulator to execute the protocol decoder tool using the first set of source files.

4. The tangible, non-transitory, computer-readable medium of claim 3, wherein the operations comprise validating the protocol decoder tool by:
transmitting input data to the simulator tool; and
validating the protocol decoder tool based on a comparison between outputted results from the protocol decoder tool and stored results in a database.

5. The tangible, non-transitory, computer-readable medium of any of the preceding claims, wherein the operations comprise:
transmitting communication in a protocol from an external device to the protocol decoder tool;
displaying an indication of the communication; and
overlaying decoded information from the protocol decoder tool onto the indication.

6. The tangible, non-transitory, computer-readable medium of claim 5, wherein the decoded information is displayed as simple text or formatted text.

7. The tangible, non-transitory, computer-readable medium of any of the preceding claims, wherein the operations comprise transmitting an injection signal to an integrated circuit device.

8. The tangible, non-transitory, computer-readable medium of claim 7, wherein the operations comprise transmitting communication in a protocol from an external device to the protocol decoder tool via an interface, and wherein the interface transmits the protocol to the protocol decoder tool in response to the protocol decoder tool calling a function of the library of callable functions.

9. The tangible, non-transitory, computer-readable medium of any of the preceding claims, wherein the second language comprises C or C++.

10. A system comprising:
a processing system comprising one or more processors; and
a memory storing instructions that, when executed by the processing system, causes the processing system to:
execute a protocol decoder tool by executing a protocol decoder module by at least one processor of the one or more processors, wherein the protocol decoder module is generated by compiling a set of source files that are converted from a hardware description language to a second language;
transmit communication in a protocol to the protocol decoder tool; and
output via a graphical user interface an indication of the communication and decoded information from the protocol decoder tool.

11. The system of claim 10, wherein the decoded information comprises a state of the protocol.

12. The system of claim 11, wherein the protocol decoder tool is executed with an interface to:
transmit the communication to the protocol decoder tool in response to the protocol decoder tool calling a first function; and
transmit the decoded information from the protocol decoder tool to at least one processor of the one or more processors in response to the protocol decoder tool calling a second function, wherein the first function and the second function are different.

13. The system of any of claims 10-12, wherein the set of source files comprises protocol decoder language in the hardware description language.

14. The system of any of claims 10-13, wherein the indication comprises at least one waveform corresponding to the protocol, and wherein the decoded information is overlaid onto the at least one waveform.

15. The system of any of claims 10-14, wherein the protocol decoder is executed with an interface to transmit an injection signal to an integrated circuit device communicatively coupled to the system.
